# EUROPÄISCHE PATENTANMELDUNG

(11) **EP 3 013 036 A1**
(43) Veröffentlichungstag der Anmeldung: **27.04.2016**
(21) Anmeldenummer: 15180869.8
(22) Anmeldetag: 13.08.2015
(51) Int. Cl.: H04N 5/33, H01L 31/113

(54) **SENSORPIXEL, VERFAHREN UND STEUERGERÄT ZUM DETEKTIEREN VON INFRAROTSTRAHLUNG**

(30) Priorität: 22.10.2014 DE 102014221403
(71) Anmelder: ROBERT BOSCH GMBH, 70442 Stuttgart (DE)
(72) Erfinder: Utermoehlen, Fabian, 70197 Stuttgart (DE); Henrici, Fabian, Palo Alto, 943041223 (US)

(57) **Zusammenfassung**

Die Erfindung betrifft ein Sensorpixel (104) zum Detektieren von Infrarotstrahlung (102), das ein Sensorelement (114) zum Erfassen einer Temperatur einer Absorberfläche (108) des Sensorpixels (104) aufweist. Die Absorberfläche (108) ist durch eine Balkenstruktur (110) von einem Substrat (112) des Sensorpixels (104) thermisch entkoppelt. Ein Drainkontakt (120) und ein Gatekontakt (122) des Sensorelements (114) sind miteinander elektrisch leitend verbunden. Ein Sourcekontakt (116) und ein Bulkkontakt (118) des Sensorelements (114) sind miteinander elektrisch leitend verbunden. Der Drainkontakt (120) und der Gatekontakt (122) sind über einen ersten Anschluss (124) elektrisch kontaktierbar. Der Sourcekontakt (116) und der Bulkkontakt (118) sind über einen zweiten Anschluss (124) elektrisch kontaktierbar. Der erste Anschluss (124) und der zweite Anschluss (124) sind in der Balkenstruktur (110) angeordnet.

## Beschreibung

### Stand der Technik

Die vorliegende Erfindung bezieht sich auf ein Sensorpixel zum Detektieren von Infrarotstrahlung, auf ein Verfahren zum Detektieren von Infrarotstrahlung, auf ein entsprechendes Steuergerät sowie auf ein entsprechendes Computerprogramm.

Infrarotstrahlung kann unter Verwendung eines fotoelektrischen Sensors registriert werden. Um dabei eine ausreichende Bildqualität zu erreichen, muss der Sensor gekühlt werden.

### Offenbarung der Erfindung

Vor diesem Hintergrund werden mit dem hier vorgestellten Ansatz ein Sensorpixel zum Detektieren von Infrarotstrahlung, ein Verfahren zum Detektieren von Infrarotstrahlung, ein Steuergerät, das dieses Verfahren verwendet sowie schließlich ein entsprechendes Computerprogramm gemäß den Hauptansprüchen vorgestellt. Vorteilhafte Ausgestaltungen ergeben sich aus den jeweiligen Unteransprüchen und der nachfolgenden Beschreibung.

Infrarotstrahlung kann durch ein Bolometer erfasst werden. Dabei erwärmt die Infrarotstrahlung eine Absorberfläche. Ein Transistor kann als Sensorelement zum Erfassen einer Temperatur der Absorberfläche verwendet werden. Der Transistor kann einfach elektrisch angeschlossen werden, da nur zwei Zuleitungen notwendig sind.

Es wird ein Sensorpixel zum Detektieren von Infrarotstrahlung vorgestellt, das ein Erfassen einer Temperatur einer Absorberfläche des Sensorpixels aufweist, wobei die Absorberfläche durch eine Balkenstruktur von einem Substrat des Sensorpixels thermisch entkoppelt ist, wobei ein Drainkontakt und ein Gatekontakt des Sensorelements miteinander elektrisch leitend verbunden sind und ein Sourcekontakt und ein Bulkkontakt des Sensorelements miteinander elektrisch leitend verbunden sind, wobei der Drainkontakt und der Gatekontakt über einen ersten Anschluss elektrisch kontaktierbar sind und der Sourcekontakt und der Bulkkontakt über einen zweiten Anschluss elektrisch kontaktierbar sind und der erste Anschluss und der zweite Anschluss in der Balkenstruktur angeordnet sind.

Das Sensorelement kann ein MOSFET sein.

Weiterhin wird ein Sensor zum Detektieren von Infrarotstrahlung vorgestellt, wobei der Sensor die folgenden Merkmale aufweist:
ein Sensorpixel gemäß dem hier vorgestellten Ansatz; und
ein Steuergerät gemäß dem hier vorgestellten Ansatz.

Ferner wird ein Verfahren zum Betreiben eines Sensorpixels gemäß dem hier vorgestellten Ansatz vorgestellt, wobei das Verfahren die folgenden Schritte aufweist:
Bereitstellen eines Sensorbetriebssignals zum Anlegen an zumindest einen der Anschlüsse des Sensorpixels unter Verwendung einer Führungsgröße;
Bestimmen eines Differenzsignals unter Verwendung eines an dem Sensorpixel resultierenden Sensormesssignals und eines Referenzsignals; und
Regeln der Führungsgröße unter Verwendung des Differenzsignals.

Unter einem Sensorpixel kann ein Bestandteil eines Bildsensors verstanden werden. Das Sensorpixel ist dazu ausgebildet ein Temperatursignal bereitzustellen, das eine Temperatur der Absorberfläche repräsentiert. Die Absorberfläche kann als Absorptionsfläche bezeichnet werden. Sourcekontakt, Drainkontakt, Gatekontakt und Bulkkontakt sind die elektrischen Anschlüsse eines Transistors.

Das Sensorbetriebssignal kann als abhängig von der Führungsgröße veränderbarer elektrischer Stromfluss bereitgestellt werden. Das Sensorbetriebssignal kann abhängig von der Temperatur des Sensorpixels bereitgestellt werden.

Das Sensorbetriebssignal kann unter Verwendung zumindest eines Digital-Analog-Konverters und eines Digitalsignals als Führungsgröße bereitgestellt werden. Ein Digitalsignal kann besonders einfach weiterverarbeitet werden.

Das Sensorbetriebssignal kann als Summe eines ersten Teilsignals und eines zweiten Teilsignals bereitgestellt werden. Das erste Teilsignal kann unter Verwendung eines ersten Digital-Analog-Konverters mit einer ersten Schrittweite bereitgestellt werden. Das zweite Teilsignal kann unter Verwendung eines zweiten Digital-Analog-Konverters mit einer zweiten Schrittweite bereitgestellt werden. Die erste Schrittweite kann größer als die zweite Schrittweite sein. Insbesondere kann die Summe der zweiten Schrittweiten einer ersten Schrittweite entsprechen. Dann kann sehr schnell und günstig ein großer Wertebereich bereitgestellt werden.

Das Sensormesssignal kann als an dem Sensorpixel abfallende elektrische Spannung eingelesen werden. Das Referenzsignal kann eine von einer Referenzspannungsquelle bereitgestellte Referenzspannung sein. Damit können zwei elektrische Spannungen verarbeitet werden, ohne das Sensorelement durch einen parasitären Stromfluss zu beeinflussen.

Im Schritt des Bestimmens kann eine Differenz zwischen dem Referenzsignal und dem Sensormesssignal gebildet werden, um das Differenzsignal zu erhalten. Ebenso kann eines der Signale invertiert werden und anschließend eine Summe der beiden Signale gebildet werden.

Die Führungsgröße kann so geregelt werden, dass das Differenzsignal gegen null geht. Damit kann direkt eine Abweichung festgestellt werden, wenn die hier vorgestellte Regelschleife aus dem Gleichgewicht ist.

Der hier vorgestellte Ansatz schafft ferner ein Steuergerät, das ausgebildet ist, um die Schritte einer Variante eines hier vorgestellten Verfahrens in entsprechenden Einrichtungen durchzuführen, anzusteuern bzw. umzusetzen. Auch durch diese Ausführungsvariante der Erfindung in Form eines Steuergeräts kann die der Erfindung zugrunde liegende Aufgabe schnell und effizient gelöst werden.

Unter einem Steuergerät kann vorliegend ein elektrisches Gerät verstanden werden, das Sensorsignale verarbeitet und in Abhängigkeit davon Steuer- und/oder Datensignale ausgibt. Das Steuergerät kann eine Schnittstelle aufweisen, die hard- und/oder softwaremäßig ausgebildet sein kann. Bei einer hardwaremäßigen Ausbildung können die Schnittstellen beispielsweise Teil eines sogenannten System-ASICs sein, der verschiedenste Funktionen des Steuergeräts beinhaltet. Es ist jedoch auch möglich, dass die Schnittstellen eigene, integrierte Schaltkreise sind oder zumindest teilweise aus diskreten Bauelementen bestehen. Bei einer softwaremäßigen Ausbildung können die Schnittstellen Softwaremodule sein, die beispielsweise auf einem Mikrocontroller neben anderen Softwaremodulen vorhanden sind.

Von Vorteil ist auch ein Computerprogrammprodukt oder Computerprogramm mit Programmcode, der auf einem maschinenlesbaren Träger oder Speichermedium wie einem Halbleiterspeicher, einem Festplattenspeicher oder einem optischen Speicher gespeichert sein kann und zur Durchführung, Umsetzung und/oder Ansteuerung der Schritte des Verfahrens nach einer der vorstehend beschriebenen Ausführungsformen verwendet wird, insbesondere wenn das Programmprodukt oder Programm auf einem Computer oder einer Vorrichtung ausgeführt wird.

Der hier vorgestellte Ansatz wird nachstehend anhand der beigefügten Zeichnungen beispielhaft näher erläutert. Es zeigen:
Fig. 1 ein Blockschaltbild eines Sensors zum Detektieren von Infrarotstrahlung gemäß einem Ausführungsbeispiel der vorliegenden Erfindung;
Fig. 2 ein Ablaufdiagramm eines Verfahrens zum Detektieren von Infrarotstrahlung gemäß einem Ausführungsbeispiel der vorliegenden Erfindung; und
Fig. 3 eine Darstellung eines Prinzips eines Auswertekonzepts zur bolometrischen Temperaturmessung gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

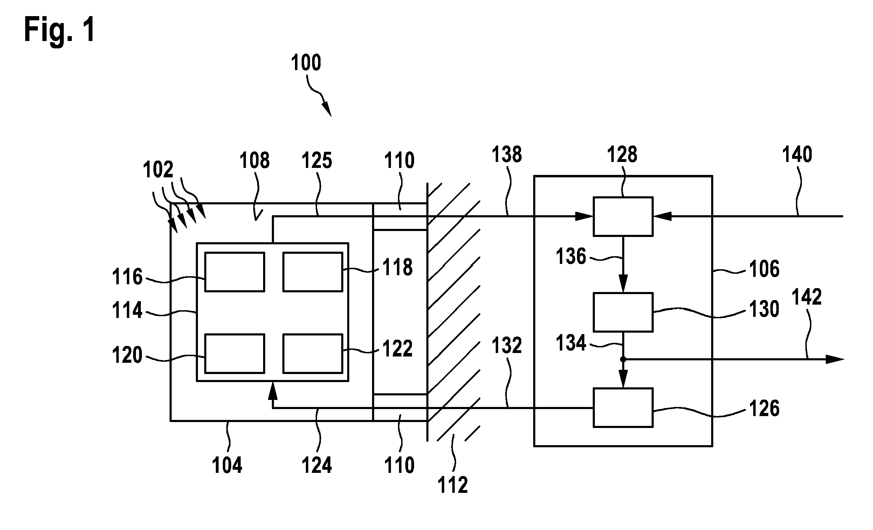

Fig. 1 zeigt ein Blockschaltbild eines Sensors 100 zum Detektieren von Infrarotstrahlung 102 gemäß einem Ausführungsbeispiel der vorliegenden Erfindung. Der Sensor 100 weist ein Sensorpixel 104 und ein Steuergerät 106 auf.

Das Sensorpixel 104 weist eine Absorberfläche 108 zum Absorbieren der Infrarotstrahlung 102 auf. Durch die absorbierte Infrarotstrahlung 102 erwärmt sich die Absorberfläche 108. Die Absorberfläche 108 ist durch eine Balkenstruktur 110 von einem Substrat 112 des Sensors 100 thermisch im Wesentlichen entkoppelt. Durch die Entkopplung wird nur wenig thermische Energie zwischen der Absorberfläche 108 und dem Substrat 112 ausgetauscht. Die Absorberfläche 108 strahlt abhängig von ihrer Temperatur Infrarotstrahlung ab. Es stellt sich eine Gleichgewichtstemperatur der Absorberfläche 108 abhängig von einer Strahlungsintensität der Infrarotstrahlung 102 ein.

Das Sensorpixel 104 weist ein Sensorelement 114 zum Erfassen der Temperatur der Absorberfläche 108 auf. Das Sensorelement 114 ist thermisch mit der Absorberfläche 108 gekoppelt. Das Sensorelement 114 ist ein Transistor 114. Bei dem Transistor 114 sind ein Sourcekontakt 116 und ein Bulkkontakt 118 elektrisch leitend miteinander verbunden. Weiter sind ein Drainkontakt 120 und ein Gatekontakt 122 elektrisch leitend miteinander verbunden. Dadurch ist der Transistor über lediglich zwei Zuleitungen 124, 125 angeschlossen, nämlich eine erste Zuleitung 124 für Drain- und Gatekontakt und eine zweite Zuleitung ist für Source- und Bulkkontakt.

In einem Ausführungsbeispiel ist der Transistor 114 ein Metalloxid-Halbleiter-Feldeffekttransistor 114 beziehungsweise ein MOSFET.

Gemäß dem in Fig. 1 gezeigten Ausführungsbeispiel sind die Zuleitungen 124, 125 mit dem Steuergerät 106 verbunden.

Das Steuergerät 106 weist eine Einrichtung 126 zum Bereitstellen, eine Einrichtung 128 zum Bestimmen und eine Einrichtung 130 zum Regeln auf. Die Einrichtung 126 zum Bereitstellen ist dazu ausgebildet, ein Sensorbetriebssignal 132 für das Sensorpixel 104 unter Verwendung einer Führungsgröße 134 bereitzustellen. Die Einrichtung 128 zum Bestimmen ist dazu ausgebildet, ein Differenzsignal 136 unter Verwendung eines an dem Sensorpixel 104 resultierenden Sensormesssignals 138 und eines Referenzsignals 140 zu bestimmen. Die Einrichtung 130 zum Regeln ist dazu ausgebildet, die Führungsgröße 134 unter Verwendung des Differenzsignals 136 zu regeln.

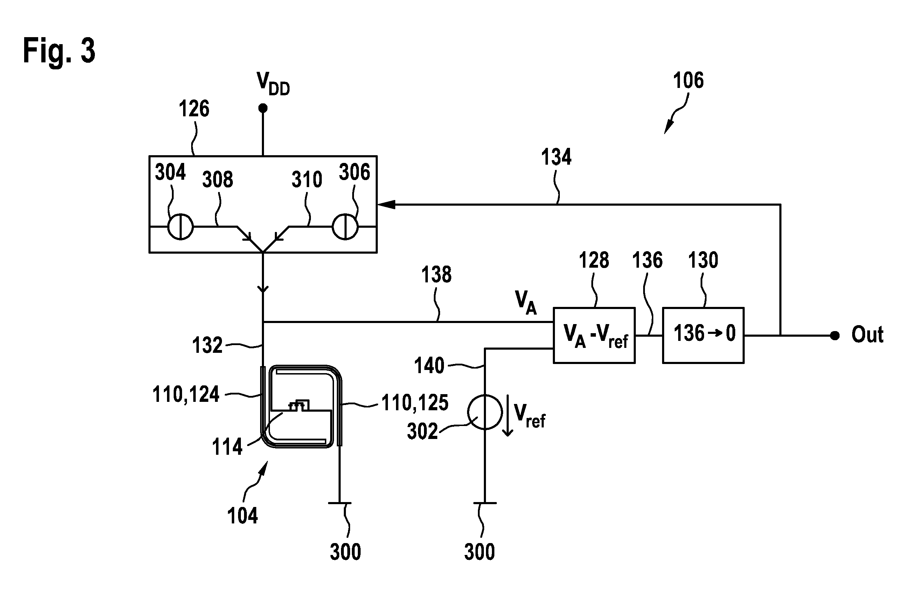

Gemäß diesem Ausführungsbeispiel ist das Steuergerät 106 ausgebildet, um das Sensorbetriebssignal 132 an einen ersten Anschluss 124 des Sensorpixels 104 anzulegen. Ferner ist das Steuergerät 106 ausgebildet, um das resultierende Sensormesssignal 138 an dem zweiten Anschluss 125 abzugreifen. Alternativ kann das Steuergerät 106 ausgebildet sein, um das resultierende Sensormesssignal 138 ebenfalls an dem ersten Anschluss 124 abzugreifen, wie es nachfolgend anhand von Fig. 3 beschrieben ist.

Die Führungsgröße 134 ist gleichzeitig eine Temperaturinformation 142, die die Temperatur am Sensorpixel 104 repräsentiert.

Durch das Regeln 130 der Führungsgröße ergibt sich eine Rückkopplung in einer Regelschleife. Damit wird das Sensorbetriebssignal 132 so eingestellt, dass das Sensormesssignal 138 einen konstanten Wert aufweist. Durch ein Anpassen des Referenzsignals kann ein Arbeitspunkt des Sensorpixels 104 beziehungsweise des Sensorelements 114 eingestellt werden.

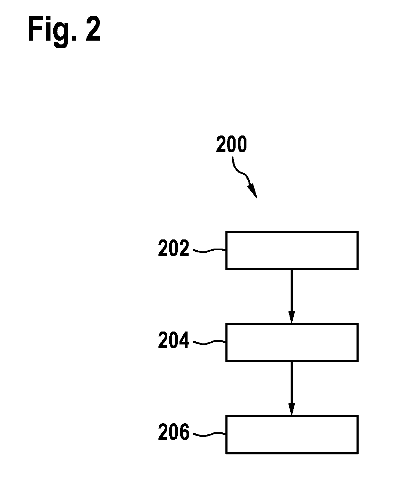

Fig. 2 zeigt ein Ablaufdiagramm eines Verfahrens 200 zum Detektieren von Infrarotstrahlung gemäß einem Ausführungsbeispiel der vorliegenden Erfindung. Das Verfahren 200 weist einen Schritt 202 des Bereitstellens, einen Schritt 204 des Bestimmens und einen Schritt 206 des Regelns auf. Im Schritt 202 des Bereitstellens wird ein Sensorbetriebssignal für das Sensorpixel unter Verwendung einer Führungsgröße bereitgestellt. Das Sensorbetriebssignal kann beispielsweise als elektrische Spannung oder als elektrischer Strom an zumindest einen der Anschlüsse des Sensorpixels angelegt werden. Im Schritt 204 des Bestimmens wird ein Differenzsignal unter Verwendung eines an dem Sensorpixel resultierenden Sensormesssignals und eines Referenzsignals bestimmt. Im Schritt 206 des Regelns wird die Führungsgröße unter Verwendung des Differenzsignals geregelt.

Fig. 3 zeigt eine Darstellung eines Prinzips eines Auswertekonzepts zur bolometrischen Temperaturmessung gemäß einem Ausführungsbeispiel der vorliegenden Erfindung. Das Auswertekonzept kann unter Verwendung eines Sensors, wie er in Fig. 1 dargestellt ist, umgesetzt werden. Wie bereits anhand von Fig. 1 beschrieben, weist das Steuergerät 106 eine Einrichtung 126 zum Bereitstellen, eine Einrichtung 128 zum Bestimmen und eine Einrichtung 130 zum Regeln auf. Bei dem Sensorelement 114 des Sensorpixels 104 sind wie in Fig. 1 der Drainkontakt und der Gatekontakt kurzgeschlossen. Ebenso sind der Sourcekontakt und der Bulkkontakt kurzgeschlossen. Das Sensorelement 114 ist über die zwei in der Balkenstruktur 110 angeordneten Zuleitungen 124, 125 elektrisch angeschlossen.

Im Gegensatz zu Fig. 1 ist ein erster Anschluss 124 des Sensorpixels 104 hier mit der Einrichtung 126 zum Bereitstellen verbunden ein zweiter Anschluss 125 des Sensorpixels 104 ist mit einem Massepotenzial 300 verbunden. Von der Einrichtung 126 zum Bereitstellen wird das Sensorpixel 104 mit einem elektrischen Stromfluss 132 als Sensorbetriebssignal 132 bestromt. Der Stromfluss 132 ist variabel. Eine an dem Sensorpixel 104 abfallende elektrische Spannung V_{A} wird von der Einrichtung 128 zum Bestimmen als Sensormesssignal 138 zwischen der Einrichtung 126 zum Bereitstellen und dem Sensorpixel 104 abgegriffen. An der Einrichtung 128 zum Bestimmen wird ferner eine Referenzspannung V_{ref} als Referenzsignal 140 von einer Referenzspannungsquelle 302 abgegriffen. Die Referenzspannungsquelle 302 ist zwischen das Massepotenzial 300 und die Einrichtung 128 zum Bestimmen geschaltet.

In der Einrichtung 128 zum Bestimmen wird als Differenzsignal 136 eine Differenz zwischen der abfallenden Spannung V_{A} und der Referenzspannung V_{ref} gebildet. Dazu wird in diesem Ausführungsbeispiel die Referenzspannung V_{ref} von der abfallenden Spannung V_{A} abgezogen.

Das Differenzsignal 136 ist die Eingangsgröße für die Einrichtung 130 zum Regeln beziehungsweise den Regler 130. Durch den Regler 130 wird die Führungsgröße 134 für die Einrichtung 126 zum Bereitstellen so lange angepasst, bis das Differenzsignal 136 gegen null geht, also die abfallende Spannung V_{A} der Referenzspannung V_{ref} entspricht. Die Führungsgröße 134 wird als Digitalsignal 134 ausgegeben.

In der Einrichtung 126 zum Bereitstellen wird die Führungsgröße 134 unter Verwendung eines groben Digital-Analog-Wandlers 304 und eines feinen Digital-Analog-Wandlers 306 in das Sensorbetriebssignal 132 umgesetzt. Dabei wird der Sensorbetriebsstrom 132 aus einem Grobanteil 308 von dem groben Digital-Analog-Wandler 304 und einem Feinanteil 310 von dem feinen Digital-Analog-Wandler 306 zusammengesetzt beziehungsweise addiert.

Die beiden Digital-Analog-Wandler 304, 306 können beispielsweise durch ein gemeinsames Datenwort der Führungsgröße 134 angesteuert werden. Dabei kann ein erstes Teilwort des Datenworts einen Wert des Grobanteils 308 festlegen und ein zweites Teilwort einen Wert des Feinanteils 310 festlegen. Ebenso können die beiden Digital-Analog-Wandler 304, 306 unter Verwendung eines Prozessors der Einrichtung 126 zum Bereitstellen angesteuert werden.

Mit anderen Worten wird ein Closed-Loop Verfahren für eine ortsaufgelöste Temperaturmessung vorgestellt. Das Verfahren basiert auf dem temperaturabhängigen Drainstrom eines MOSFETs 114 im Subthreshold Betrieb.

MOSFETs 114 können als temperatursensitive Bauelemente 114 auf Mikrobolometer-Pixeln 104 eingesetzt werden. Damit kann eine hohe Temperatursensitivität erreicht werden, die Größenordnungen über resistiven Materialien liegt. Die Temperatursensitivität ist über die angelegte Spannung einstellbar. MOSFETs 114 weisen ein hohes Miniaturisierungspotenzial auf.

Es wird ein closed-loop Auswerteprinzip zur Temperaturmessung beschrieben, das auf dem bolometrischen Prinzip basiert, bei dem als temperaturempfindliches Bauelement 114 ein MOSFET 114 verwendet wird, der auf dem Pixel 104 so verschaltet ist, dass nur zwei Anschlüsse 124 nach außen geführt sind. Der ASIC 106 kann mit nahezu jedem ASIC Prozess kostengünstig hergestellt werden.

Eine bekannte Möglichkeit für ein temperatursensitives Bauelement ist der Einsatz von einigen pn-Dioden in Serie. Die Messgröße ist dabei die Differenzspannung zweier Pixel bei identischer Bestromung. Bei dem ersten Pixel handelt es sich dabei um ein aktives Pixel, welches durch eine große thermische Isolation und damit einen hohen Temperaturhub bei Einstrahlung gekennzeichnet ist. Das zweite Pixel ist dabei thermisch deutlich besser an das Substrat angebunden und dient der Kompensation der Eigenerwärmung durch die Bestromung selbst und der Kompensation des hohen Offsets in Folge der Chiptemperatur. Diese Kompensation ist notwendig, da das eigentliche Messsignal nur einige mV bei einem Offset von ca. 2.5 V beträgt.

Bei dem hier vorgestellten Ansatz kann auf das Referenzpixel verzichtet werden. Dies ermöglicht ein erheblich kleineres MEMS Array 104 und damit verringerte Systemkosten, vor allem aufgrund der sehr teuren Optik, deren Kosten mit der Arraygröße skalieren.

Die Messung basiert prinzipiell auf einer Strommessung bei konstanter Spannung. Diese wird über V_{ref} vorgegeben. Der MOSFET 114 ist auf dem Pixel 104 so verschaltet, dass der Drainkontakt mit dem Gatekontakt und der Sourcekontakt mit dem Bulkkontakt verbunden sind. Dementsprechend werden nur zwei Anschlüsse 124 vom Pixel 104 zur Auswerteschaltung 106 geführt.

Der eingezeichnete Digital-Analog-Wandler DAC 126 (Digital-to-Analog-Converter) stellt den benötigten Betriebsstrom 132 für den Pixeltransistor 114 bereit. Er besteht intern aus einer groben Stromquelle 304 und einer feinen Stromquelle 306. Die sich über dem Transistor 114 einstellende Spannung 138 wird mit einer Referenzspannung V_{ref} verglichen und die Differenz 136 zu null geregelt. Das Regelsignal 134 für den DAC 126 stellt gleichzeitig den Ausgang und Messwert der Schaltung 106 dar. Damit wird der Pixeltransistor 114 im closed-loop Betrieb ausgewertet.

Durch den Transistor 114 fließt abhängig von Fertigungsstreuungen und der Grundtemperatur des Chips 104 ein Grundstrom. Zusätzlich fließt der eigentliche Messstrom, d. h. die Veränderung des Gesamtstromes aufgrund der eingestrahlten thermischen Leistung. Dieser ist sehr gering im Vergleich zum Grundstrom. Insgesamt beträgt der Wertebereich ca. 0-2 µA, darauf kann ein Temperaturstrom mit 1 pA aufgelöst werden.

Ein einstufiger DAC 126 kann dazu mit mehr als 20 bit Auflösung ausgeführt werden.

Vorteilhafterweise erfolgt eine Unterteilung in einen Fein-DAC 306 und einen Grob-DAC 304.

Mit dem Grob-DAC 304 werden im Millihertzbereich (mHz) sehr langsam Temperaturschwankungen des Chips 104 und gleichzeitig Prozesstoleranzen ausgeregelt. Dieser Wert kann für ein komplettes Pixelarray identisch sein.

Mit dem Fein-DAC 306 wird im Kilohertzbereich bis Megahertzbereich (kHz-MHz) schnell die Änderung des Stromes 132 aufgrund der eingestrahlten Energie beziehungsweise Erwärmung ausgeregelt. Dieser Teil des DAC 126 stellt das eigentliche Messsignal dar.

Der Fein-DAC 306 deckt ungefähr den erwarteten Wertebereich aufgrund der Einstrahlung ab.

Damit der Fein-DAC 306 nicht aus seinem Wertebereich herausläuft wird über den Grob-DAC 304 langsam die Chiptemperatur ausgeglichen.

Ein vorteilhafter Wertebereich für den Fein-DAC 306 sind ca. 10 bit und Imax =1 nA. Ein vorteilhafter Wertebereich für den Grob-DAC 304 sind ca. 11 bit und 1.2 µA.

Über Änderung der Referenzspannung V_{ref} kann der Arbeitsbereich des Transistors 114 eingestellt werden, z. B. um seine Grundempfindlichkeit an die Anwendung anzupassen. Vorteilhafterweise liegt der Arbeitspunkt im Bereich maximaler Temperaturempfindlichkeit bei ca. 0.5 V.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden. Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Sensorpixel (104) zum Detektieren von Infrarotstrahlung (102), mit einem Sensorelement (114) zum Erfassen einer Temperatur einer Absorberfläche (108) des Sensorpixels (104), wobei die Absorberfläche (108) durch eine Balkenstruktur (110) von einem Substrat (112) des Sensorpixels (104) thermisch entkoppelt ist, wobei ein Drainkontakt (120) und ein Gatekontakt (122) des Sensorelements (114) miteinander elektrisch leitend verbunden sind und ein Sourcekontakt (116) und ein Bulkkontakt (118) des Sensorelements (114) miteinander elektrisch leitend verbunden sind, wobei der Drainkontakt (120) und der Gatekontakt (122) über einen ersten Anschluss (124) elektrisch kontaktierbar sind und der Sourcekontakt (116) und der Bulkkontakt (118) über einen zweiten Anschluss (125) elektrisch kontaktierbar sind und der erste Anschluss (124) und der zweite Anschluss (125) in der Balkenstruktur (110) angeordnet sind.

2. Sensorpixel (104) gemäß Anspruch 1, bei dem das Sensorelement (114) ein MOSFET (114) ist.

3. Sensor (100) zum Detektieren von Infrarotstrahlung (102), wobei der Sensor (100) die folgenden Merkmale aufweist:
ein Sensorpixel (104) gemäß einem der Ansprüche 1 bis 2; und
ein Steuergerät (106) gemäß Anspruch 11.

4. Verfahren (200) zum Betreiben eines Sensorpixels (104) gemäß einem der Ansprüche 1 bis 2, wobei das Verfahren (200) die folgenden Schritte aufweist:
Bereitstellen (202) eines Sensorbetriebssignals (132) zum Anlegen an zumindest einen der Anschlüsse (124) des Sensorpixels (104) unter Verwendung einer Führungsgröße (134);
Bestimmen (204) eines Differenzsignals (136) unter Verwendung eines an dem Sensorpixel (104) resultierenden Sensormesssignals (138) und eines Referenzsignals (140); und
Regeln (206) der Führungsgröße (134) unter Verwendung des Differenzsignals (136).

5. Verfahren (200) gemäß Anspruch 4, bei dem im Schritt (202) des Bereitstellens das Sensorbetriebssignal (132) als abhängig von der Führungsgröße (134) veränderbarer elektrischer Stromfluss (132) bereitgestellt wird.

6. Verfahren (200) gemäß einem der vorangegangenen Ansprüche, bei dem im Schritt (202) des Bereitstellens das Sensorbetriebssignal (132) unter Verwendung zumindest eines Digital-Analog-Konverters (304, 306) und eines Digitalsignals (132) als Führungsgröße (132) bereitgestellt wird.

7. Verfahren (200) gemäß Anspruch 6, bei dem im Schritt (202) des Bereitstellens das Sensorbetriebssignal (132) als Summe eines ersten Teilsignals (308) und eines zweiten Teilsignals (310) bereitgestellt wird, wobei das erste Teilsignal (308) unter Verwendung eines ersten Digital-Analog-Konverters (304) mit einer ersten Schrittweite bereitgestellt wird, und das zweite Teilsignal (310) unter Verwendung eines zweiten Digital-Analog-Konverters (310) mit einer zweiten Schrittweite bereitgestellt wird, wobei die erste Schrittweite größer als die zweite Schrittweite ist.

8. Verfahren (200) gemäß einem der vorangegangenen Ansprüche, bei dem im Schritt (204) des Bestimmens das Sensormesssignal (138) als an dem Sensorpixel (106) abfallende elektrische Spannung (VA) eingelesen wird, wobei das Referenzsignal (140) eine von einer Referenzspannungsquelle (302) bereitgestellte Referenzspannung (V_{ref}) ist.

9. Verfahren (200) gemäß einem der vorangegangenen Ansprüche, bei dem im Schritt (204) des Bestimmens eine Differenz zwischen dem Referenzsignal (140) und dem Sensormesssignal (138) gebildet wird, um das Differenzsignal (136) zu erhalten.

10. Verfahren (200) gemäß einem der vorangegangenen Ansprüche, bei dem im Schritt (206) des Regelns die Führungsgröße (134) so geregelt wird, dass das Differenzsignal (136) gegen null geht.

11. Steuergerät (106) zum Betreiben eines Sensorpixels (104), das ausgebildet ist, um alle Schritte eines Verfahrens gemäß einem der vorangegangenen Ansprüche durchzuführen.

12. Computerprogramm, das dazu eingerichtet ist, alle Schritte eines Verfahrens gemäß einem der vorangegangenen Ansprüche durchzuführen.

13. Maschinenlesbares Speichermedium mit einem darauf gespeicherten Computerprogramm nach Anspruch 12.
